**Europäisches Patentamt**

**European Patent Office**

**Office européen des brevets**

(11) Publication number: **0 408 368 A2**

# EUROPEAN PATENT APPLICATION

(21) Application number: 90307653.7

(51) Int. Cl.⁵: **G11C 5/14**, G11C 16/06

(22) Date of filing: **12.07.90**

(30) Priority: 14.07.89 JP 183101/89

(43) Date of publication of application:
**16.01.91 Bulletin 91/03**

(84) Designated Contracting States:
**DE GB**

(71) Applicant: **SEIKO INSTRUMENTS INC.**
**31-1, Kameido 6-chome Koto-ku**
**Tokyo 136(JP)**

(72) Inventor: **Konishi, Haruo, c/o Seiko**
**Instruments Inc.**
**31-1, Kameido 6-chome, Koto-ku**
**Tokyo(JP)**

(74) Representative: **Caro, William Egerton et al**
**J. MILLER & CO. Lincoln House 296-302 High**
**Holbornorn**
**London WC1V 7JH(GB)**

(54) Semi-conductor non-volatile memory device.

(57) A semi-conductor non-volatile memory device has a voltage booster and a supply voltage detection circuit (1, 2, 3; 10, 11) arranged to be operative only when the voltage booster is operated to detect a power supply voltage which is applied to the voltage booster and which is boosted thereby to power a non-volatile memory device.

## FIG. 1

BOOSTER CONTROL SIGNAL

20

B

C VOLTAGE BOOSTER

OUTPUT

SUPPLY VOLTAGE DETECTION CIRCUIT

EP 0 408 368 A2

## SEMI-CONDUCTOR NON-VOLATILE MEMORY DEVICE

This invention relates to semi-conductor non-volatile memory devices.

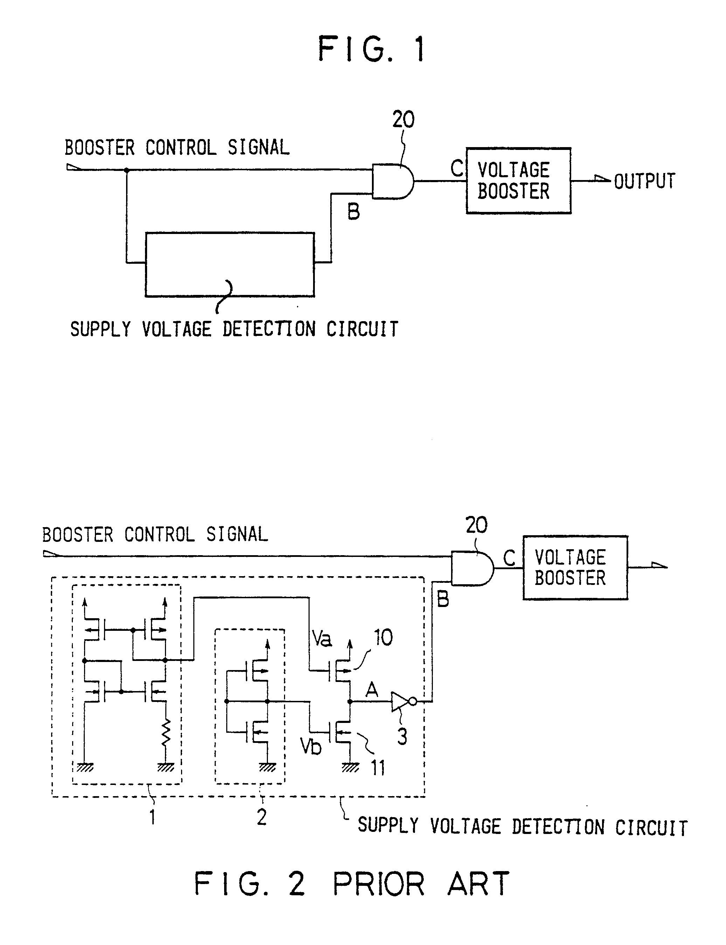

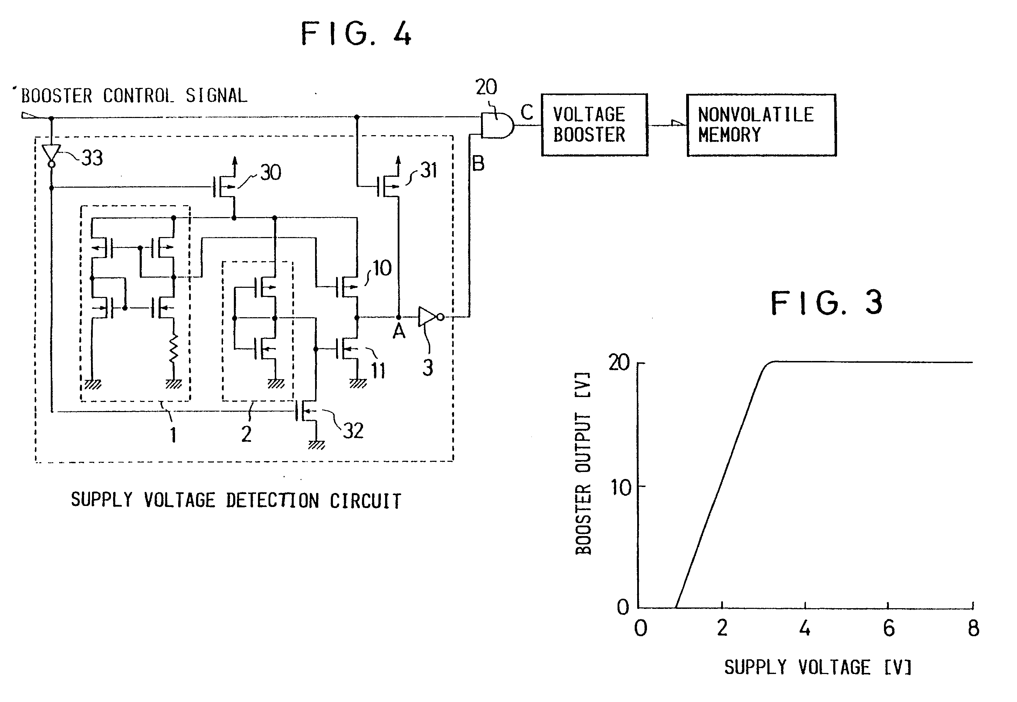

Generally, re-writing of a semi-conductor non-volatile memory device requires a high operating voltage, for example, about 20 V. Figure 3 illustrates the performance of a voltage booster, where it can be seen that the voltage booster cannot generate a desired high voltage when power supply voltage falls below a critical level, for example, 2.5 V. Therefore, a non-volatile memory device cannot effect a re-writing operation when the power supply voltage falls below this level. In view of this, as shown in Figure 2, conventionally a power source voltage detection circuit is utilised and is always operated so as forcibly to inhibit operation of the voltage booster when the detection circuit detects that the power supply voltage falls below a certain level, for example, 3.0 V even if an enabling signal has been generated to operate the voltage booster, thereby preventing erroneous or insufficient re-writing of the non-volatile memory device.

The power source voltage detection circuit includes a constant voltage circuit 1 operative to apply constant voltage Va to a gate electrode of a P-channel transistor 10 to enable the same to cause a constant current $I_{10}$ to flow. Then, a circuit 2 applies a voltage Vb dependent on the power supply voltage to a gate electrode of an N-channel transistor 11. When the power supply voltage is below a pre-determined level, the N-channel transistor 11 is turned OFF to hold a node A at "H" level. Therefore, an output terminal B of the supply voltage detection circuit is held at "L" level. On the other hand, when the supply voltage exceeds the pre-determined level, the N-channel transistor 11 is turned ON to lower the voltage level of the node A below an inversion voltage of an inverter 3. Consequently, the output terminal B of the supply voltage detection circuit is turned to "H" level. As a result, when the power supply voltage is below the pre-determined level, the output of the supply voltage detection circuit is held at "L" level. Therefore, an input terminal C of the voltage booster is held at "L" level effective to inhibit operation of the voltage booster even if a control signal is turned to "H" level so as to enable the voltage booster.

However, the conventional supply voltage detection circuit is always in an operative state even at times when a boosting operation is unnecessary, thereby causing the drawback that unnecessary current is consumed.

The present invention seeks to provide a semi-conductor non-volatile memory device wherein a supply voltage detection circuit is controlled in an inoperative state thereby to limit current consumption to leakage current.

According to the present invention there is provided a semi-conductor non-volatile memory device having a voltage booster and characterised by a supply voltage detection circuit arranged to be operative only when the voltage booster is operated to detect a power supply voltage which is applied to the voltage booster and which is boosted thereby to power a non-volatile memory device.

Preferably logic means is arranged to receive a booster control signal and an output signal from the supply voltage detection circuit to provide an output to operate the voltage booster in the presence of the booster control signal and when the power supply voltage is above a pre-determined level. The logic means may be an AND gate.

The supply voltage detection circuit may include a constant voltage circuit and a circuit for producing a voltage dependent on the power supply voltage, and means for comparing outputs of the circuits to produce the output signal when the power supply voltage is above the pre-determined level.

In such a construction, upon receipt of a control signal effective to initiate the voltage booster, the supply voltage detection circuit starts to operate to detect whether the supply voltage is above a pre-determined voltage level. According to the result of this detection, the operation of the voltage booster is controlled such that current consumption of the supply voltage detection circuit can be reduced to substantially only leakage current when the voltage booster is in a stand-by state.

The invention is illustrated, merely by way of example, in the accompanying drawings, in which:-

Figure 1 is a schematic block diagram of a booster control circuit of a semi-conductor non-volatile memory device according to the present invention;

Figure 2 is a diagram of a conventional booster control circuit;

Figure 3 is a waveform diagram of a voltage booster; and

Figure 4 is a circuit diagram of a booster control circuit of a semi-conductor non-volatile memory device according to the present invention.

Referring to Figure 1, a semi-conductor non-volatile memory device according to the present invention operates so that a booster control signal is held at "H" level when initiating operation of a voltage booster and is held at "L" level when placing the voltage booster in a stand-by state. A supply voltage detection circuit operates when the booster control signal is "L" level to output an "L" level signal, and operates when the booster control signal is "H" level to detect the power supply voltage, such that when the power supply voltage is above a pre-determined level, the "H" level signal is outputted, and when the power supply voltage is below the pre-determined level an "L" level signal is outputted. The voltage booster operates when its input is held at "H" level" to produce a boosted voltage, and operates when its input is held at "L" level to output a "L" level signal. The booster control signal is fed to an input terminal of the supply voltage detection circuit and to one input of a two input AND circuit 20. An output terminal B of the supply voltage detection circuit is connected to the other input of the AND circuit 20 whose output is connected to an input terminal C of the voltage booster.

Next description is given of the operation. Firstly, when inhibiting operation of the voltage booster, the booster control signal is turned to "L" level to hold the input terminal C of the voltage booster at "L" level. Concurrently at this time, the output terminal B of the supply voltage detection circuit is held also at "L" level. Next, when operating the voltage booster, the booster control signal is turned to "H" level to set the supply voltage detection circuit in the operative state. Then, the supply voltage detection circuit outputs a "H" level signal when the supply voltage is above the pre- determined reference voltage level so that the input terminal C of the voltage booster is turned to "H" level effective to start operation of the voltage booster. On the other hand, when the supply voltage is below the reference level, the detection circuit outputs an "L" level signal so that the input terminal of the voltage booster is maintained at "L" level to avoid operation of the voltage booster.

Figure 4 is a detailed circuit diagram showing an embodiment of the present invention, constructed such that P-channel transistors 30, 31, an N-channel transistor 32 and an inverter 33 are added to the conventional supply voltage detection circuit shown in Figure 2. The P-channel transistor 30 is inter-connected between a supply voltage line and the constant voltage circuit 1, the circuit 2 for outputting a voltage dependent on the supply voltage and the P-channel transistor 10. The N-channel transistor 32 is connected between a gate electrode of the N-channel transistor 11 and a ground line. The gate electrodes of the respective P-channel transistor 30 and the N-channel transistor 32 are inputted with the booster control signal inverted by the inverter 33. Further, the P-channel transistor 31 is inter-connected between an input terminal of the inverter 3 and the supply voltage line, and the gate electrode of the P-channel transistor 31 receives the booster control signal. The booster control signal and the signal at the output terminal B of the supply voltage detection circuit are applied to respective input terminals of the two input AND circuit 20 whose output is connected to the input terminal C of the voltage booster which supplies a boosted voltage to a non-volatile memory.

Next description is given of the operation of the embodiment of Figure 4. Firstly, when inhibiting operation of the voltage booster, the booster control signal is turned to "L" level to hold the input terminal C of the booster at "L" level. At this time, the gate electrode of the P-channel transistor 30 is held at "H" level through the inverter 33 so as to turn OFF the P-channel transistor 30. Consequently, no power supply voltage is applied to the constant voltage circuit 1, the circuit 2 for outputting a voltage dependent on the supply voltage and the P-channel transistor 10 thereby to limit current consumption of the supply voltage detection circuit to only leakage current. Further, the gate electrode of the N-channel transistor 32 is held also at "H" level to turn ON the N-channel transistor 32. Consequently, the gate of the N-channel transistor 11 is held at "L" level to turn OFF the N-channel transistor 11. The gate electrode of the P-channel transistor 31 is held to "L" level to turn ON the P-channel transistor 31. Consequently, the node A is held at "H" level and the output terminal B of the supply voltage detection circuit is held at "L" level through the inverter 3. The P-channel transistor 31 and the N-channel transistor 32 co-operate to fix the node A to "L" level so as to eliminate a feedback current in the inverter 3.

Next, when operating the voltage booster, the booster control signal is turned to "H" level so that the gate electrode of the P-channel transistor 30 is set to "L" level so as to turn ON the P-channel transistor 30 thereby to apply the power supply voltage to the constant voltage circuit 1, the circuit 2 for outputting a voltage dependent on the supply voltage and the P-channel transistor 10 to power those circuits. At this time, the gate electrode of the P-channel transistor 31 is set to "H" level and the gate electrode of the N-channel transistor 32 is set to "L" level through the inverter 33. Therefore, both the P-channel transistor 31 and the N-channel transistor 32 are turned OFF such that the node A is not set to "H" level. Then, in a similar manner to the conventional booster control circuit shown in Figure 2, the supply voltage detection circuit of Figure 4 outputs an "H" level signal when the power supply voltage is above a pre-determined level so that the input terminal C of the voltage booster is turned to "H" level to start operation thereof. On the other hand, when the power supply voltage is below the pre-determined level, the supply voltage detection circuit outputs an "L" level signal so that the input terminal C of the voltage booster is held at "L" level to suspend its operation. As described, the supply voltage detection circuit is operated or powered only when operating the voltage booster. Therefore, current consumption can be saved within the amount of leakage current in the supply voltage detection circuit when the voltage booster is not operated.

As described above, the supply voltage detection circuit is controlled according to the booster control signal to operate only when voltage boosting is in operation. Therefore, during other periods, the current consumption is limited to leakage current, thereby advantageously reducing power consumption particularly in a stand-by period.

## Claims

1. A semi-conductor non-volatile memory device having a voltage booster and characterised by a supply voltage detection circuit arranged to be operative only when the voltage booster is operated to detect a power supply voltage which is applied to the voltage booster and which is boosted thereby to power a non-volatile memory device.

2. A semi-conductor non-volatile memory device as claimed in claim 1 characterised in that a logic means (20) is arranged to receive a booster control signal and an output signal from the supply voltage detection circuit to provide an output to operate the voltage booster in the presence of the booster control signal and when the power supply voltage is above a pre-determined level.

3. A semi-conductor non-volatile memory device as claimed in claim 2 characterised in that the logic means is an AND gate (20).

4. A semi-conductor non-volatile memory device as claimed in claim 2 or 3 characterised in that the supply voltage detection circuit includes a constant voltage circuit (1) and a circuit (2) for producing a voltage dependent on the power supply voltage, and means (10, 11) for comparing outputs of the circuits (1, 2) to produce the output signal when the power supply voltage is above the pre-determined level.

# FIG. 1

BOOSTER CONTROL SIGNAL

20

C | VOLTAGE BOOSTER | → OUTPUT

B

SUPPLY VOLTAGE DETECTION CIRCUIT

BOOSTER CONTROL SIGNAL

20

C | VOLTAGE BOOSTER

B

Va 10

A

Vb 11

3

1 2

SUPPLY VOLTAGE DETECTION CIRCUIT

# FIG. 2 PRIOR ART

# FIG. 4

BOOSTER CONTROL SIGNAL

SUPPLY VOLTAGE DETECTION CIRCUIT

VOLTAGE BOOSTER

NONVOLATILE MEMORY

# FIG. 3

BOOSTER OUTPUT [V]

SUPPLY VOLTAGE [V]

EP 0 408 368 A2